# EUROPÄISCHE PATENTSCHRIFT

(11) **EP 4 176 315 B1**
(45) Veröffentlichungstag und Bekanntmachung des Hinweises auf die Patenterteilung: **19.06.2024**
(21) Anmeldenummer: 21739996.3
(22) Anmeldetag: 01.07.2021
(51) Int. Cl.: G03F 7/20, G02B 5/08

(54) **OPTISCHES ELEMENT, OPTISCHES SYSTEM, LITHOGRAPHIEANLAGE UND VERFAHREN ZUM BETREIBEN EINES OPTISCHEN ELEMENTS**
OPTICAL ELEMENT, OPTICAL SYSTEM, LITHOGRAPHY SYSTEM, AND METHOD FOR OPERATING AN OPTICAL ELEMENT
ÉLÉMENT OPTIQUE, SYSTÈME OPTIQUE, INSTALLATION DE LITHOGRAPHIE ET PROCÉDÉ DE FONCTIONNEMENT D'UN ÉLÉMENT OPTIQUE

(30) Priorität: 06.07.2020 DE 102020208415
(43) Veröffentlichungstag der Anmeldung: 10.05.2023
(73) Patentinhaber: Carl Zeiss SMT GmbH, 73447 Oberkochen (DE)
(72) Erfinder: KIMLING, Johannes, 73431 Aalen (DE); GRAF, Peter, 89551 Königsbronn (DE); WABRA, Norbert, 97440 Werneck (DE); SCHNEIDER, Sonja, 73447 Oberkochen (DE); FINKEN, Reimar, 73463 Westhausen (DE)
(74) Vertreter: Horn Kleimann Waitzhofer Schmid-Dreyer Patent- und Rechtsanwälte PartG mbB
(86) Internationale Anmeldenummer: PCT/EP2021/068161
(87) Internationale Veröffentlichungsnummer: WO 2022/008336

(56) Entgegenhaltungen:
- EP-A2- 2 650 730
- DE-A1-102008 023 238
- DE-A1-102010 047 839
- US-A- 4 730 900

## Beschreibung

Die vorliegende Erfindung betrifft ein optisches Element für eine Lithographieanlage, ein optisches System, eine Lithographieanlage und ein Verfahren zum Betreiben eines derartigen optischen Elements.

Die Mikrolithographie wird zur Herstellung mikrostrukturierter Bauelemente, wie beispielsweise integrierter Schaltkreise, angewendet. Der Mikrolithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat, beispielsweise einen Siliziumwafer, projiziert, um die Maskenstruktur auf die lichtempfindliche Beschichtung des Substrats zu übertragen.

Insbesondere während der Belichtung des Wafers kann es zu einer nicht rotationssymmetrischen, lichtinduzierten Erwärmung eines optischen Elements (Spiegel oder Linse) der Projektionsbelichtungsanlage (auch "Projektionssystem" benannt) kommen. Diese lokalen Erwärmungen können eine entsprechende nicht rotationssymmetrische Ausdehnung des optischen Elements und eine nicht rotationssymmetrische Brechungsindexverteilung des optischen Elements zur Folge haben, wodurch die Abbildungsqualität des optischen Elements reduziert wird.

Bei hohen Anforderungen an die Abbildungsqualität, wie sie insbesondere bei Projektionsbelichtungsverfahren in der Mikrolithographie gefordert sind, können die beschriebenen lichtinduzierten Abbildungsfehler nicht toleriert werden.

Eine Möglichkeit zur Reduzierung der beschriebenen Abbildungsfehler ist, auf dem optischen Element an bestimmten Stellen zu heizen, insbesondere gegenzuheizen.

Solch ein Heizen beschreiben die Dokumente US 5,679,946 A, US 2003/0169520 A1 und US 4,730,900 A. Diese Dokumente zeigen jeweils eine optische Anordnung mit Temperatursensoren, die eine Temperatur eines optischen Elements messen, und Heizelementen, die in Abhängigkeit der durch die Sensoren gemessenen Temperatur das optische Element heizen.

Bei den beschriebenen Lösungen wird die Gegenheizmenge individuell in Abhängigkeit der erfassten Temperatur berechnet, wofür Rechenleistung benötigt wird. Ferner wird eine Änderung der Beleuchtungseinstellungen nur mit zeitlicher Verzögerung im Minutenbereich über ein gemessenes Temperaturprofil detektiert. Im Einzelfall ist das nicht schnell genug und ermöglicht insbesondere keine Korrektur der Temperatur innerhalb der Beleuchtungszeit eines Wafers.

Eine alternative Lösung, mit der Verformungen des optischen Elements kompensiert werden, ohne auf Informationen über die Lichtbelastung auf dem optischen Element abzustellen, ist zum Beispiel in dem Dokument US 5,883,704 A beschrieben. Darin wird eine Temperatur eines optischen Elements einer Projektionsbelichtungsanlage mit einer Temperatursteuerung derart verändert, dass anhand eines Sensors, der eine Bildverzerrung misst, eine bessere Bildqualität erfasst wird. Die Bildqualität zu erfassen ist jedoch aufwändig. Ferner kann die Belichtung erst nach der Temperaturanpassung erfolgen.

Vor diesem Hintergrund besteht eine Aufgabe der vorliegenden Erfindung darin, ein verbessertes optisches Element für eine Lithographieanlage bereitzustellen.

Gemäß einem ersten Aspekt wird ein optisches Element für eine Lithographieanlage vorgeschlagen. Das optische Element umfasst:
eine optische Oberfläche, und
einen Fotowiderstand mit einem elektrischen Fotowiderstandswert, welcher in Abhängigkeit einer Lichtmenge, die auf einen Bereich der optischen Oberfläche einfällt, variiert.

Mithilfe des Fotowiderstands kann auf den Bereich der optischen Oberfläche einfallendes Licht gemessen werden. Die Messung des einfallenden Lichts ist insbesondere für das Gegenheizen der Stellen, an denen kein Licht einfällt, vorteilhaft. Die einfallende Lichtmenge wird direkt durch den Fotowiderstandswert angegeben. Ein separater Temperatursensor zur Messung der Temperatur, um daraus die einfallende Lichtmenge abzuleiten, kann entfallen.

Bei Einschalten der Projektionsbelichtungsanlage und/oder bei Änderungen der Belichtungseinstellungen kann die Lichtabsorption durch die optische Oberfläche sehr schnell, insbesondere im Millisekundenbereich, mithilfe des Fotowiderstands erfasst werden. Ein vollständiges und zuverlässiges Absorptionsbild des Bereichs der optischen Oberfläche kann mit geringen zeitlichen Verzögerungen und ohne auf eine Temperaturmessung zurückgreifen zu müssen, erhalten werden.

Das optische Element kann ein Spiegel oder eine Linse sein. Insbesondere handelt es sich bei dem optischen Element um ein optisches Element der Projektionsbelichtungsanlage einer Lithographieanlage, zum Beispiel einer EUV- ("extreme ultraviolet") oder einer DUV- ("deep ultraviolet") Lithographieanlage. Während des Betriebs der Lithographieanlage, zum Beispiel während der Belichtung des Wafers, können unterschiedliche Lichtmengen auf unterschiedliche Bereiche der optischen Oberfläche des optischen Elements einfallen und zu den zuvor bereits beschriebenen Verformungen und unerwünschten optischen Aberrationen führen.

Die optische Oberfläche ist insbesondere eine Oberfläche des optischen Elements, auf die beim Betrieb in der Lithographieanlage (insbesondere bei der Belichtung bei einer Chipherstellung) Arbeitslicht trifft. Bei der optischen Oberfläche kann es sich somit um die Oberfläche des optischen Elements handeln, die optisch belastet ist. Die optische Oberfläche ist zum Beispiel eine Spiegeloberfläche oder eine Linsenoberfläche. Die optische Oberfläche kann insbesondere in mehrere Bereiche aufgeteilt werden. Jeder Bereich der optischen Oberfläche umfasst zumindest einen Teil der optischen Oberfläche. Die Bereiche können zum Beispiel eine rechteckige oder eine runde Form haben.

Der Fotowiderstand ist ein lichtempfindliches elektrisches Bauelement. Der elektrische Fotowiderstandswert (auch "Fotowiderstandswert" oder "Widerstandswert") ist ein Parameter des Fotowiderstands, der von der absorbierten Lichtleistung abhängt. Mindestens einem Bereich der optischen Oberfläche kann ein Fotowiderstand derart zugeordnet sein, dass die Lichtmenge, die auf den Bereich der optischen Oberfläche einfällt, proportional zur Lichtmenge ist, die auf den Fotowiderstand einfällt. Der Fotowiderstand ist dabei beispielsweise unterhalb des zugeordneten Bereichs angeordnet. Je mehr Licht auf den Fotowiderstand fällt, desto kleiner wird sein elektrischer Widerstandswert. Die Ursache für diese Funktion ist der innere fotoelektrische Effekt in einer Schicht des Fotowiderstands, die aus einem Halbleiter (beispielsweise aus einem amorphen oder kristallinen Halbleiter) besteht.

Der Fotowiderstand ist insbesondere nanostrukturiert. Denkbare Dimensionen des Fotowiderstands sind zum Beispiel 160 x 200 x 20nm, wobei zusätzlich noch Metallkontakte dazukommen können. Der Fotowiderstand sollte insbesondere nahe an der optischen Oberfläche angeordnet sein, damit er das einfallende Licht erfassen kann. Der Widerstandswert variiert beispielsweise im MegaohmBereich.

Der Fotowiderstand wird beispielsweise inklusive Kontakte und Leiterbahnen auf die Oberfläche eines optischen Elements aufgebracht. Dann wird eine Quauarzschicht aufgebracht, und diese wird im Rahmen der Oberflächenbearbeitung geglättet. Bei Linsen ist es insbesondere wichtig, dass die Fläche des Widerstands klein genug ist, um nicht zu viel einfallendes Licht zu absorbieren oder zu streuen.

Der Fotowiderstand ist insbesondere dem Bereich der optischen Oberfläche zugeordnet. Das bedeutet zum Beispiel, dass der Fotowiderstand die auf den Bereich einfallende Lichtmenge erfasst und/oder unter dem entsprechenden Bereich angeordnet ist.

Gemäß einer Ausführungsform ist der Fotowiderstand geeignet, das optische Element (insbesondere den Bereich) in Abhängigkeit des elektrischen Fotowiderstandswerts derart zu beheizen, dass das Beheizen eine Verformung des optischen Elements (insbesondere des Bereichs), die aufgrund des einfallenden Lichts erfolgt, ausgleicht und/oder eine Brechungsindexänderung, die aufgrund des einfallenden Lichts erfolgt, ausgleicht.

Ausgleichen bedeutet insbesondere, dass die optische Wirkung der Deformation und/oder der Brechungsindexänderung reduziert und/oder symmetrisiert wird. Dadurch kann die optische Wirkung der Deformation und/oder der Brechungsindexänderung besser korrigiert werden.

Der Fotowiderstand ist insbesondere geeignet, den Bereich in Abhängigkeit des elektrischen Fotowiderstandswerts derart zu beheizen, dass ein Wärmeeintrag in diesem Bereich aufgrund des einfallenden Lichts durch eine reduzierte elektrische Heizleistung ausgeglichen wird.

Das Beheizen durch den Fotowiderstand dient insbesondere dem Gegenheizen des Bereichs der optischen Oberfläche, auf den kein oder wenig Licht einfällt. Durch das Beheizen des Bereichs kann die Erwärmung des optischen Elements durch Lichtabsorption kompensiert werden, wodurch das optische Element insbesondere gleichmäßig und/oder rotationssymmetrisch verformt wird. Dadurch können unerwünschte optische Aberrationen verhindert werden.

Der Fotowiderstand funktioniert insbesondere zusätzlich zur Lichtmengenerfassung als ein Heizwiderstand, der elektrische Energie in thermische Energie (Wärme) umwandelt. Die Heizleistung des Fotowiderstands ist insbesondere umso höher, desto weniger Licht auftritt (großer Widerstand). Der Fotowiderstand kann dabei mit einer Stromstärke von wenigen Milliamperes (mA) bestromt werden. Ein Beheizen durch den Fotowiderstand vorzusehen, ist zum Beispiel deshalb vorteilhaft, weil eine Änderung des Fotowiderstandswerts eine direkte Auswirkung auf die erzeugte Wärme hat. Das Gegenheizen ist daher mit geringem Aufwand realisierbar.

Gemäß einer weiteren Ausführungsform umfasst das optische Element ferner ein Heizelement, das geeignet ist, den Bereich in Abhängigkeit des elektrischen Fotowiderstandswerts zu beheizen.

Das Heizelement dient insbesondere dem Gegenheizen eines Bereichs der optischen Oberfläche, auf den kein oder wenig Licht einfällt. Durch das Beheizen des Bereichs kann für die Erwärmung des optischen Elements durch Lichtabsorption kompensiert werden.

Die Heizleistung des Heizelements kann proportional zum Widerstandswert sein. Um den Bereich in Abhängigkeit des Fotowiderstandswerts zu beheizen, kann das Heizelement direkt in einem Stromkreis mit dem Fotowiderstand gekoppelt sein oder alternativ ein Steuersignal erhalten, welches in Abhängigkeit des Widerstandswerts von einer Steuereinheit erzeugt wird.

Das Heizelement ist insbesondere kein Fotowiderstand. Es kann vielmehr zusätzlich zum Fotowiderstand vorgesehen sein. Das Heizelement umfasst zum Beispiel eine Widerstandsheizung, insbesondere einen Heizdraht, oder ein Infrarot-Heizelement (IR-Heizelement). Bei der Widerstandsheizung wird beispielsweise ein leitfähiges Material des Heizelements mit Strom durchflossen, wodurch joulesche Wärme erzeugt wird. Eine Widerstandsheizung als Heizelement vorzusehen, ist zum Beispiel deshalb vorteilhaft, weil eine Änderung des Fotowiderstandswerts eine direkte Auswirkung auf die das Heizelement durchströmende Strommenge hat und somit die erzeugte Wärme direkt steuert.

Bei dem IR-Heizelement kann es sich beispielsweise um einen Infrarotlaser oder um eine breitbandige IR-Strahlungsquelle, beispielsweise eine Infrarotlampe, handeln, welche Heizstrahlung mit einer geeigneten Heizleistung erzeugt. Es versteht sich, dass ggf. auch Strahlung bei anderen Wellenlängen als im IR-Wellenlängenbereich als Heizstrahlung verwendet werden kann.

Zusätzlich zum Heizen mit dem Fotowiderstand noch ein Heizelement vorzusehen, ist deshalb vorteilhaft, weil die Heizkapazität dadurch erhöht werden kann. Insbesondere sind der Fotowiderstandswert und ein Widerstandswert des Heizelements ungefähr gleich. In diesem Fall wird die Gesamtheizleistung aus Fotowiderstand und Heizelement durch den Fotowiderstandswert gesteuert.

Der Fotowiderstand, das Heizelement oder einer Kombination aus Fotowiderstand und Heizelement erzeugt beim Heizen des optischen Elements insbesondere eine Flächenheizleistungsdichte von mindestens 100 W/m², vorzugsweise von mindestens 200 W/m², vorzugsweise von mindestens 500 W/m². Diese Flächenheizleistungsdichte können auch mehrere Fotowiderstände und/oder Heizelemente, die im optischen Element verteilt angeordnet sind, gemeinschaftlich erbringen.

Gemäß einer weiteren Ausführungsform ist das Heizelement parallel zum Fotowiderstand geschaltet. Das Heizelement ist insbesondere in einem Stromkreis elektrisch parallel mit dem Fotowiderstand verbunden. Das Heizelement und der Fotowiderstand können direkt miteinander gekoppelt sein, sodass die Gesamtheizleistung durch den Fotowiderstandswert gesteuert wird.

Gemäß einer weiteren Ausführungsform ist das Heizelement in einem Stromkreis elektrisch mit dem Fotowiderstand verbunden, und eine Änderung des elektrischen Fotowiderstandswerts ändert einen Gesamtwiderstand des Stromkreises derart, dass sich ein Beheizen des Bereichs durch das Heizelement verändert.

Die durch das Heizelement erzeugte Wärme ist insbesondere abhängig von der Strommenge, die das Heizelement durchfließt. Eine Veränderung des Fotowiderstands induziert eine Veränderung des Gesamtwiderstands des Stromkreises, wodurch das Beheizen des Bereichs variiert. Der Fotowiderstand kann somit als Regelelement für die Gesamtheizleistung des Stromkreises verwendet werden.

Der Stromkreis umfasst insbesondere das Heizelement, den Fotowiderstand und eine Stromquelle (vorzugsweise eine Gleichstromquelle). Der Stromkreis kann zusätzliche elektrische Komponenten, wie beispielsweise einen weiteren Widerstand oder ein Spannungsmessgerät, umfassen. Die einzelnen Komponenten des Stromkreises können in Serie und/oder parallel geschaltet sein.

Gemäß einer weiteren Ausführungsform ist das Heizelement eingerichtet, den Bereich umso mehr zu beheizen, desto größer der elektrische Fotowiderstandswert ist.

Je weniger Licht auf den Fotowiderstand fällt, desto größer wird sein elektrischer Widerstandswert. Aufgrund des bei wenig Licht steigenden Fotowiderstandswerts wird ein Gesamtwiderstand des Stromkreises erhöht und die Heizleistung des Heizelements steigt. Es wird insbesondere ein Bereich, auf den wenig Licht tritt, mehr beheizt als ein Bereich, auf den mehr Licht tritt. Je mehr Licht auf den Bereich einfällt, desto weniger wird er durch das Heizelement beheizt. Ein sehr stark absorbierender Bereich wird insbesondere gar nicht beheizt. Dadurch können optische Aberrationen besonders effizient verhindert werden.

Gemäß einer weiteren Ausführungsform ist der Fotowiderstand und/oder das Heizelement in einem Substrat des optischen Elements angeordnet, wobei das Substrat unterhalb des Bereichs der optischen Oberfläche angeordnet ist. Der Fotowiderstand ist insbesondere direkt unterhalb der Schicht, die die optische Oberfläche bildet, angeordnet. Der Fotowiderstand ist insbesondere als eine Folie ausgebildet.

Gemäß einer weiteren Ausführungsform umfasst das optische Element mehrere Fotowiderstände und/oder mehrere Heizelemente, wobei jeweils ein Fotowiderstand und ein Heizelement zusammen ein Heizmodul bilden, und wobei jedes Heizmodul geeignet ist, einen unterschiedlichen Bereich der optischen Oberfläche zu beheizen.

Insbesondere ist die optische Oberfläche in mehrere Bereiche unterteilt, wobei jedem Bereich ein Heizmodul zugeordnet ist, dessen Fotowiderstand den Fotowiderstandswert des Bereichs erfasst und welches den Bereich entsprechend beheizt. Dadurch kann die gesamte optische Oberfläche in Abhängigkeit des absorbierten Lichts geheizt werden und optische Aberrationen werden verhindert.

Gemäß einer weiteren Ausführungsform ist jedes Heizmodul geeignet, durch eine eigene Stromleitung mit Strom versorgt zu werden, und wobei die Stromleitungen in dem Substrat des optischen Elements angeordnet sind und insbesondere parallel zueinander verlaufen.

Die Stromleitungen sind insbesondere einzeln steuerbare Leitungen, die in dem Substrat verlaufen und jeweils ein Heizmodul mit Strom (Gleichstrom) versorgen. Die Stromleitungen verbinden die Heizmodule zum Beispiel mit einer gemeinsamen Gleichstromquelle oder mit separaten Gleichstromquellen. Die Fotowiderstände und/oder die Heizmodule können parallel zueinander nebeneinander oder leicht versetzt zueinander angeordnet sein.

Gemäß einer weiteren Ausführungsform umfasst das optische Element zumindest eine Stromleitung, die mit mehreren Heizmodulen verbunden ist und geeignet ist, diese mit Strom zu versorgen, insbesondere gemäß einem Multiplexverfahren.

Diese Ausführungsform hat den Vorteil, dass insgesamt weniger Stromleitungen benötigt werden, um die Heizmodule mit Strom zu versorgen. Dazu können die Heizmodule in einer Matrixanordnung angeordnet sein. Jede Spalte und jede Reihe der Heizmodulmatrixanordnung wird insbesondere anhand genau einer Stromleitung mit Strom versorgt. Bei einer Matrixanordnung mit NxN Fotowiderständen und/oder Heizmodulen (also mit N Spalten und N Reihen an Fotowiderständen und/oder Heizmodulen) werden insbesondere 2N Stromleitungen benötigt, während bei der einzelnen Ansteuerung mit separaten Stromleitungen insbesondere N² Stromleitungen benötigt werden.

Das Multiplexverfahren zur Stromversorgung zeichnet sich insbesondere dadurch aus, dass Spalten und/oder Reihen der Matrix nacheinander mit Strom versorgt werden, wobei diese Stromversorgung im Zyklus wiederholt wird.

Gemäß einer weiteren Ausführungsform umfasst der Fotowiderstand zumindest ein Halbleitermaterial, wobei das Halbleitermaterial insbesondere amorphes Silizium-Kohlenstoffnitrid (SiCN) oder eine Siliziumkohlenstoff-Legierung (SiCH) umfasst.

SiCN ist ein Beispiel für ein Halbleitermaterial mit einer hohen Sensitivität im UV-Bereich und eignet sich daher besonders für Anwendungen in einer EUV- oder DUV-Lithographieanlage. Als weiteres Material mit größerer elektrischer Leitfähigkeit eignet sich beispielsweise p-dotiertes nanokristallines SiC:H (mit Wasserstoff versetztes Siliziumcarbid). Der Doppelpunkt gibt an, dass zwischen den Chemikalien SiC und H eine Bindung vorliegt.

Die Dunkelleitfähigkeit (Leitfähigkeit des Fotowiderstands nach mehreren Sekunden Dunkelheit) und die Fotoleitfähigkeit (auch "Hellleitfähigkeit", Leitfähigkeit des Fotowiderstands bei 1000 lx) des Fotowiderstands können über Dotierung und Schichtdicke eingestellt werden. Bei 60nm Dicke betragen Dunkel- und Fotoleitfähigkeiten für SiC:H etwa 10 und 15 Ω⁻¹.

Als Material für den Fotowiderstand eignen sich aber grundsätzlich auch andere Halbleiter. Der Halbleiter sollte Bandlücken unterhalb der Photonenenergie des verwendeten Lichts haben. Aufgrund des in Lithographieanlagen gegebenen Wellenlängenspektrums der Beleuchtung ist eine Selektivität (besonders hohe Sensitivität) im UV-Bereich nicht zwingend notwendig, weil Licht anderer ungewollter Wellenlängen ohnehin nicht auf den Fotowiderstand fällt.

Gemäß einem zweiten Aspekt wird ein optisches System für eine Lithographieanlage vorgeschlagen. Dieses weist auf:
ein optisches Element gemäß dem ersten Aspekt oder gemäß einer Ausführungsform des ersten Aspekts, und
zumindest eine Gleichstromquelle, die geeignet ist, den Fotowiderstand und/oder das Heizelement mit Strom zu versorgen, und/oder
eine Steuereinheit, die geeignet ist, in Abhängigkeit des elektrischen Fotowiderstandswerts das Beheizen des Bereichs der optischen Oberfläche durch den Fotowiderstand und/oder durch das Heizelement anzusteuern, und/oder
ein externes Heizelement, insbesondere ein IR-Heizelement, das geeignet ist, einen Bereich in Abhängigkeit des elektrischen Fotowiderstandswerts zu beheizen.

Um das Beheizen anzusteuern, kann die Steuereinheit insbesondere eine Stromversorgung des Fotowiderstands und/oder des Heizelements variieren. Die Steuereinheit kann hierzu mit der Gleichstromquelle verbunden sein und diese ansteuern, um den Fotowiderstand und/oder das Heizelement mit einem geeigneten Strom zu versorgen. Die Steuereinheit steuert die Gleichstromquelle insbesondere derart an, dass Fotowiderstände und Heizelement mit einem Multiplexverfahren mit Strom versorgt werden.

Alternativ kann die Steuereinheit das Heizelement auch ansteuern, indem es ein Steuersignal, welches von dem Fotowiderstandswert abhängig ist, an das Heizelement überträgt. Diese Variante findet insbesondere bei externen Heizelementen Anwendung, die zum Beispiel als IR-Heizelemente ausgebildet sind. Extern bedeutet in diesem Zusammenhang, dass das Heizelement weder in dem optischen Element noch in Kontakt zu dem optischen Element angeordnet ist.

Gemäß einem dritten Aspekt wird eine Lithographieanlage, insbesondere EUV- oder DUV-Lithographieanlage, mit einem optischen Element gemäß dem ersten Aspekt oder gemäß einer Ausführungsform des ersten Aspekts oder mit einem optischen System gemäß dem zweiten Aspekt oder gemäß einer Ausführungsform des zweiten Aspekts vorgeschlagen.

Die EUV-Lithographieanlage verwendet insbesondere Licht mit einer Wellenlänge im Bereich von 0,1 nm bis 30 nm, insbesondere 13,5 nm. Die DUV-Lithographieanlage verwendet insbesondere Licht mit Wellenlängen von 248 oder 193 nm.

Gemäß einem vierten Aspekt wird ein Verfahren zum Betreiben eines optischen Elements einer Lithographieanlage, insbesondere zum Betreiben des optischen Elements gemäß dem ersten Aspekt oder gemäß einer Ausführungsform des ersten Aspekts, vorgeschlagen. Das Verfahren umfasst:
Erfassen eines elektrischen Fotowiderstandswerts eines Fotowiderstands, wobei der elektrische Fotowiderstandswert in Abhängigkeit einer Lichtmenge, die auf einen Bereich der optischen Oberfläche einfällt, variiert; und
Beheizen der optischen Oberfläche, insbesondere des Bereichs, in Abhängigkeit des elektrischen Fotowiderstandswerts.

Durch das Erfassen des elektrischen Fotowiderstandswerts wird insbesondere ein Messsensor gebildet, mit dem ein durch den Bereich absorbiertes Licht erfasst wird. Anwendung kann solch ein Messsensor sowohl in DUV- als auch in EUV-Lithographieanlagen finden. Es ist zudem möglich, den Fotowiderstandswert in einer Standardspeichereinheit (zum Beispiel in einer RAM) zu speichern.

Die für das optische Element beschriebenen Ausführungsformen und Merkmale gelten für das vorgeschlagene optische System, die vorgeschlagene Lithographieanlage sowie das vorgeschlagene Verfahren entsprechend und umgekehrt.

Gemäß einer Ausführungsform erfolgt das Beheizen der optischen Oberfläche mit dem Fotowiderstand und/oder einem Heizelement.

Gemäß einer weiteren Ausführungsform umfasst das Verfahren ferner:
Beheizen des Bereichs in Abhängigkeit des elektrischen Fotowiderstandswert mithilfe eines Heizelements, das elektrisch mit dem Fotowiderstand verbunden ist, wobei eine Änderung des elektrischen Fotowiderstandswerts einen Gesamtwiderstand des Stromkreises derart ändert, dass sich ein Beheizen des Bereichs durch das Heizelement verändert; und/oder
Ansteuern des Heizelements in Abhängigkeit des erfassten elektrischen Fotowiderstandswerts durch die Steuereinheit; und/oder
Beheizen eines Bereichs aufweisend einen Kleberschutz in Abhängigkeit des elektrischen Fotowiderstandswerts mithilfe des Heizelements, wobei der Kleberschutz einen Kleber überdeckt, der zum Verbinden des optischen Elements mit einer Halterung verwendet wird.

Das zuvor beschriebene optische Element und/oder optische System kann in unterschiedliche Art und Weise in der Lithographieanlage verwendet werden. Zum einen ist ein direktes Beheizen des Bereichs mit dem Fotowiderstand und/oder dem Heizelement in Abhängigkeit des Fotowiderstands möglich.

Ferner kann die Steuereinheit zusätzlich in Abhängigkeit des Widerstandswerts Steuersignale an das Heizelement liefern. Diese Ausführungsform findet insbesondere in EUV-Lithographieanlagen Anwendung, bei denen externe IR-Heizelemente Spiegel erwärmen und so in Abhängigkeit einer einfallenden Lichtmenge angesteuert werden können.

Eine weitere Anwendung findet das optische Element bzw. das optische System im Kleberbereich einer DUV-Lithographieanlage. Das optische Element kann nämlich mit Kleber an einer Halterung (Rahmen) befestigt sein. Da der Kleber durch Bestrahlung beschädigt werden kann, wird er durch einen Kleberschutz vor der Einstrahlung geschützt. Der Kleberschutz absorbiert Licht jedoch stark, wodurch im Bereich des Kleberschutzes eine starke Verformung des optischen Elements erfolgt. Diese wird insbesondere dadurch kompensiert, dass der Fotowiderstand und/oder das Heizelement den Bereich in Abhängigkeit des Fotowiderstandswerts beheizen. Insbesondere beheizt der Fotowiderstand und/oder das Heizelement den Bereich des Kleberschutzes, auf den Licht fällt, in Abhängigkeit des Fotowiderstands weniger, als den Bereich des Kleberschutzes, auf den kein Licht fällt.

"Ein" ist vorliegend nicht zwingend als beschränkend auf genau ein Element zu verstehen. Vielmehr können auch mehrere Elemente, wie beispielsweise zwei, drei oder mehr, vorgesehen sein. Auch jedes andere hier verwendete Zählwort ist nicht dahingehend zu verstehen, dass eine Beschränkung auf genau die genannte Anzahl von Elementen gegeben ist. Vielmehr sind zahlenmäßige Abweichungen nach oben und nach unten möglich, soweit nichts Gegenteiliges angegeben ist.

Weitere mögliche Implementierungen der Erfindung umfassen auch nicht explizit genannte Kombinationen von zuvor oder im Folgenden bezüglich der Ausführungsbeispiele beschriebenen Merkmalen oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1A zeigt eine schematische Ansicht einer Ausführungsform einer EUV-Lithographieanlage;
Fig. 1B zeigt eine schematische Ansicht einer Ausführungsform einer DUV-Lithographieanlage;
Fig. 2 zeigt eine Draufsicht eines optischen Elements gemäß einer ersten Ausführungsform;
Fig. 3 zeigt eine Schnittansicht des optischen Elements der Fig. 2;
Fig. 4 zeigt eine Seitenansicht eines Fotowiderstands;
Fig. 5 zeigt ein Verhältnis einer Leitfähigkeit diverser Materialen zur Schichtdicke;
Fig. 6A zeigt eine Schnittansicht eines optischen Systems gemäß einer ersten Ausführungsform mit einem optischen Element gemäß einer zweiten Ausführungsform;
Fig. 6B zeigt einen Stromkreis für das optische System der Fig. 6A;
Fig. 7A zeigt ein Verhältnis zwischen dem elektrischen Fotowiderstandswert und der Heizleistung des Heizelements;
Fig. 7B zeigt ein Verhältnis zwischen dem elektrischen Fotowiderstandswert und der Heizleistung des Fotowiderstands;
Fig. 7C zeigt ein Verhältnis zwischen dem elektrischen Fotowiderstandswert und der gesamten Heizleistung des Stromkreises;
Fig. 8 zeigt ein erstes Beispiel für eine Anordnung einer Vielzahl von Heizmodulen;
Fig. 9 zeigt ein zweites Beispiel für eine Anordnung einer Vielzahl von Heizmodulen;
Fig. 10 zeigt eine Schnittansicht eines optischen Systems gemäß einer zweiten Ausführungsform mit einem optischen Element gemäß einer dritten Ausführungsform;
Fig. 11 zeigt eine Schnittansicht eines optischen Systems gemäß einer dritten Ausführungsform mit einem optischen Element gemäß einer vierten Ausführungsform; und
Fig. 12 zeigt eine Schnittansicht eines optischen Systems gemäß einer vierten Ausführungsform mit einem optischen Element gemäß einer fünften Ausführungsform.

In den Figuren sind gleiche oder funktionsgleiche Elemente mit denselben Bezugszeichen versehen worden, soweit nichts Gegenteiliges angegeben ist. Ferner sollte beachtet werden, dass die Darstellungen in den Figuren nicht notwendigerweise maßstabsgerecht sind.

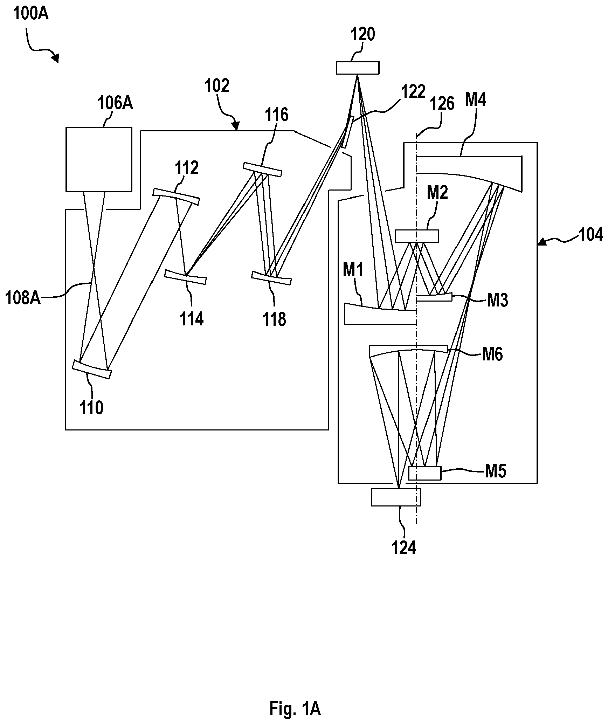

Fig. 1A zeigt eine schematische Ansicht einer EUV-Lithographieanlage 100A, welche ein Strahlformungs- und Beleuchtungssystem 102 und ein Projektionssystem 104 umfasst. Dabei steht EUV für "extremes Ultraviolett" (Engl.: extreme ultraviolet, EUV) und bezeichnet eine Wellenlänge des Arbeitslichts zwischen 0,1 nm und 30 nm. Das Strahlformungs- und Beleuchtungssystem 102 und das Projektionssystem 104 sind jeweils in einem nicht gezeigten Vakuum-Gehäuse vorgesehen, wobei jedes Vakuum-Gehäuse mit Hilfe einer nicht dargestellten Evakuierungsvorrichtung evakuiert wird. Die Vakuum-Gehäuse sind von einem nicht dargestellten Maschinenraum umgeben, in welchem Antriebsvorrichtungen zum mechanischen Verfahren beziehungsweise Einstellen von optischen Elementen vorgesehen sind. Ferner können auch elektrische Steuerungen und dergleichen in diesem Maschinenraum vorgesehen sein.

Die EUV-Lithographieanlage 100A weist eine EUV-Lichtquelle 106A auf. Als EUV-Lichtquelle 106A kann beispielsweise eine Plasmaquelle (oder ein Synchrotron) vorgesehen sein, welche Strahlung 108A im EUV-Bereich (extrem ultravioletter Bereich), also beispielsweise im Wellenlängenbereich von 5 nm bis 20 nm, aussendet. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlformungs- und Beleuchtungssystem 102 und im Projektionssystem 104 evakuiert sind.

Das in Fig. 1A dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf eine Photomaske (Engl.: reticle) 120 geleitet. Die Photomaske 120 ist ebenfalls als reflektives optisches Element ausgebildet und kann außerhalb der Systeme 102, 104 angeordnet sein. Weiter kann die EUV-Strahlung 108A mittels eines Spiegels 122 auf die Photomaske 120 gelenkt werden. Die Photomaske 120 weist eine Struktur auf, welche mittels des Projektionssystems 104 verkleinert auf einen Wafer 124 oder dergleichen abgebildet wird.

Das Projektionssystem 104 (auch als Projektionsobjektiv bezeichnet) weist sechs Spiegel M1 bis M6 zur Abbildung der Photomaske 120 auf den Wafer 124 auf. Dabei können einzelne Spiegel M1 bis M6 des Projektionssystems 104 symmetrisch zu einer optischen Achse 126 des Projektionssystems 104 angeordnet sein. Es sollte beachtet werden, dass die Anzahl der Spiegel M1 bis M6 der EUV-Lithographieanlage 100A nicht auf die dargestellte Anzahl beschränkt ist. Es können auch mehr oder weniger Spiegel M1 bis M6 vorgesehen sein. Des Weiteren sind die Spiegel M1 bis M6 in der Regel an ihrer Vorderseite zur Strahlformung gekrümmt.

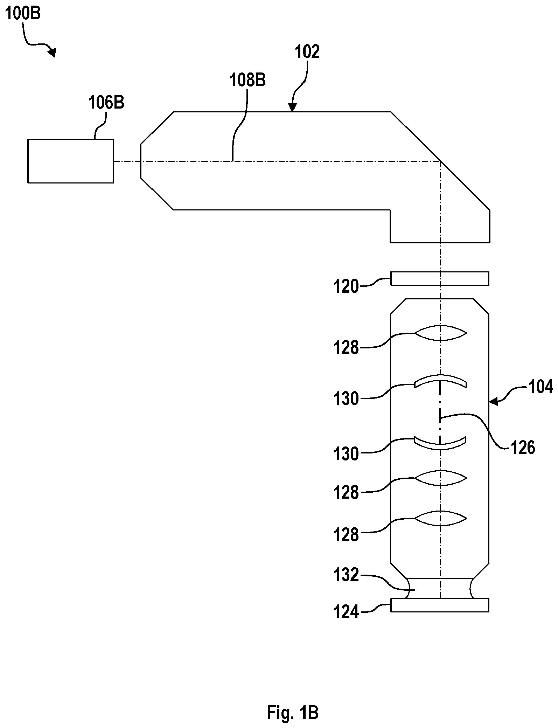

Fig. 1B zeigt eine schematische Ansicht einer DUV-Lithographieanlage 100B, welche ein Strahlformungs- und Beleuchtungssystem 102 und ein Projektionssystem 104 umfasst. Dabei steht DUV für "tiefes Ultraviolett" (Engl.: deep ultraviolet, DUV) und bezeichnet eine Wellenlänge des Arbeitslichts zwischen 30 nm und 250 nm. Das Strahlformungs- und Beleuchtungssystem 102 und das Projektionssystem 104 können - wie bereits mit Bezug zu Fig. 1A beschrieben - in einem Vakuumgehäuse angeordnet und/oder von einem Maschinenraum mit entsprechenden Antriebsvorrichtungen umgeben sein.

Die DUV-Lithographieanlage 100B weist eine DUV-Lichtquelle 106B auf. Als DUV-Lichtquelle 106B kann beispielsweise ein ArF-Excimerlaser vorgesehen sein, welcher Strahlung 108B im DUV-Bereich bei beispielsweise 193 nm emittiert.

Das in Fig. 1B dargestellte Strahlformungs- und Beleuchtungssystem 102 leitet die DUV-Strahlung 108B auf eine Photomaske 120. Die Photomaske 120 ist als transmissives optisches Element ausgebildet und kann außerhalb der Systeme 102, 104 angeordnet sein. Die Photomaske 120 weist eine Struktur auf, welche mittels des Projektionssystems 104 verkleinert auf einen Wafer 124 oder dergleichen abgebildet wird.

Das Projektionssystem 104 weist mehrere Linsen 128 und/oder Spiegel 130 zur Abbildung der Photomaske 120 auf den Wafer 124 auf. Dabei können einzelne Linsen 128 und/oder Spiegel 130 des Projektionssystems 104 symmetrisch zu einer optischen Achse 126 des Projektionssystems 104 angeordnet sein. Es sollte beachtet werden, dass die Anzahl der Linsen 128 und Spiegel 130 der DUV-Lithographieanlage 100B nicht auf die dargestellte Anzahl beschränkt ist. Es können auch mehr oder weniger Linsen 128 und/oder Spiegel 130 vorgesehen sein. Des Weiteren sind die Spiegel 130 in der Regel an ihrer Vorderseite zur Strahlformung gekrümmt.

Ein Luftspalt zwischen der letzten Linse 128 und dem Wafer 124 kann durch ein flüssiges Medium 132 ersetzt sein, welches einen Brechungsindex > 1 aufweist. Das flüssige Medium 132 kann beispielsweise hochreines Wasser sein. Ein solcher Aufbau wird auch als Immersionslithographie bezeichnet und weist eine erhöhte photolithographische Auflösung auf. Das Medium 132 kann auch als Immersionsflüssigkeit bezeichnet werden.

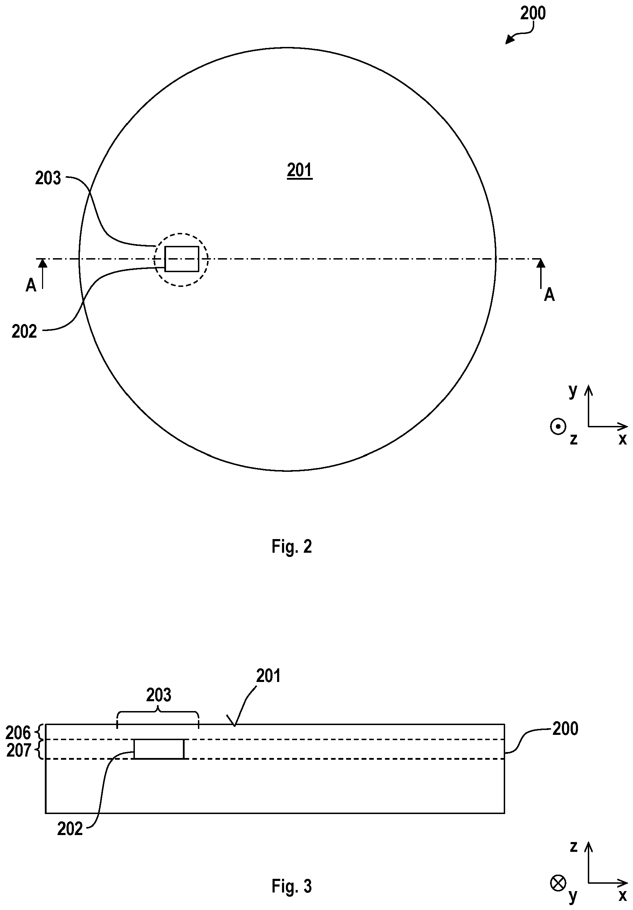

Die Fig. 2 zeigt eine Draufsicht eines optischen Elements 200 gemäß einer ersten Ausführungsform. Die Fig. 3 zeigt zudem eine Schnittansicht des optischen Elements 200 der Fig. 2 entlang der Schnittlinie A-A. Das optische Element 200 ist beispielsweise eine der Linsen 128 des Projektionssystems 104 der DUV-Lithographieanlage 100B. Alternative kann es sich bei dem optischen Element 200 beispielsweise auch um einen Spiegel 130 handeln, oder das optische Element 200 kann Teil des Projektionssystems 104 der EUV-Lithographieanlage 100A sein.

Die Linse 200 ist in Draufsicht im Wesentlichen rund und hat einen Durchmesser von etwa 10 bis 15 cm. Allgemein sind in anderen Ausführungsformen jedoch Durchmesser von bis zu 35 cm denkbar. In der Darstellung der Fig. 2 blickt man auf eine optische Oberfläche 201 der Linse 200. Die optische Oberfläche 201 ist die Oberfläche, auf die die DUV-Strahlung 108B während des Betriebs der Lithographieanlage 100B einfällt. Die optische Oberfläche 201 weist einen kreisförmigen Bereich 203 auf, der einem Bereich der optischen Oberfläche 201 entspricht, unter dem in der Linse 200 ein Fotowiderstand 202 vorgesehen ist.

Wie in der Fig. 2 sichtbar, ist der Fotowiderstand 202 in einem Substrat 207 vorgesehen, welches eine Schicht der Linse 200 bildet, die direkt unterhalb einer die optische Oberfläche 201 aufweisende Oberflächenschicht 206 angeordnet ist. Der Fotowiderstand 202 kann das Licht erfassen, das auf einen Bereich 203 der optischen Oberfläche 201 einfällt. Der Bereich 203 ist zumindest unmittelbar über dem Fotowiderstand 202 gebildet. Der Bereich 203 kann sich ferner etwas um den unmittelbar über dem Fotowiderstand 202 erstreckenden Abschnitt erstrecken, wie es zum Beispiel aus der Fig. 2 ersichtlich ist, weil dort einfallendes Licht auch durch den Fotowiderstand 202 erfasst wird. Der Bereich 203 hier ist ein kreisförmiger Bereich der optischen Oberfläche 201.

Der Fotowiderstand 202 hat einen Fotowiderstandswert R_{Foto}, der in Abhängigkeit davon, wie viel Licht 108A auf den Bereich 203 und somit auf den Fotowiderstand 202 einfällt, variiert.

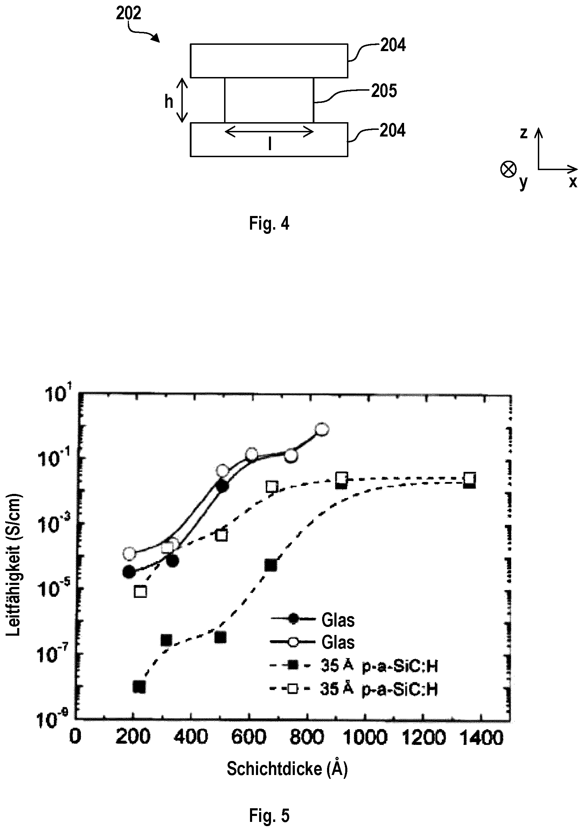

Die Fig. 4 zeigt eine Seitenansicht des Fotowiderstands 202. Der Fotowiderstand 202 umfasst einen Halbleiter 205, der zwischen zwei Metallkontakten 204 angeordnet ist. Der Halbleiter 205 hat eine Höhe h von 60nm, eine Breite (in der Fig. 4 nicht ersichtlich, da sie sich entlang der Y-Richtung erstreckt) von 200nm und eine Länge 1 von 150 nm.

Der Halbleiter 205 ist aus p-dotiertem nanokristallinen SiC:H. Dieses Material hat Bandlücken unterhalb der Photonenenergie des verwendeten DUV-Lichts 108B.

Die Fig. 5 zeigt ein Verhältnis einer Leitfähigkeit diverser Materialen zur Schichtdicke, wobei die Kreise Glas und die Quadrate p-dortiertem amorphem SiC:H (p-a SiC:H) entsprechen. Die schwarz gefüllten Formen geben die Leitfähigkeit ohne Bestrahlung (Dunkelleitfähigkeit), die weiß gefüllten Formen geben die Leitfähigkeit unter Bestrahlung (Fotoleitfähigkeit) an. Die Fig. 5 stammt aus dem Artikel" Ultrathin boron-doped microcrystalline silicon as a novel constant band gap buffer inserted at the p-a-SiC:H/i-a-Si:H interface of amorphous silicon solar cells", Journal of Applied Physics 87, 8778 (2000).

Die Fig. 5 zeigt, dass die Leitfähigkeit von Glas kaum von der Lichteinstrahlung abhängig ist. Die Leitfähigkeit von SiC:H hängt jedoch stark von der Lichteinstrahlung ab, insbesondere bei dünnen Schichtdicken (geringer als 800 Å). Daher eignet sich SiC:H als Halbleitermaterial für den Halbleiter 205 des Fotowiderstands 202.

Mithilfe des Fotowiderstands 202 kann die Lichtmenge, die auf den Bereich 203 einfällt, direkt bestimmt werden. Eine Temperaturmessung am Bereich 203 ist nicht erforderlich. Die Menge an einfallendem Licht wird durch den elektrischen Fotowiderstandswert R_{Foto} wiedergegeben. Je weniger Licht 108B auf den Bereich 203 trifft, desto größer wird der elektrische Fotowiderstandswert R_{Foto}. Demzufolge erwärmt der Fotowiderstand 202 den Bereich 203. Je größer der elektrische Fotowiderstandswert R_{Foto}, desto größer ist die Wärmeleistung durch den Fotowiderstand 202.

Der Fotowiderstand 202 erwärmt die optische Oberfläche 201 lokal in Abhängigkeit von dem einfallenden Licht 108B und gleicht somit Verformungen und/oder Brechungsindexänderungen aus, die durch Lichtabsorption auftreten. Dadurch werden vorteilhaft optische Aberrationen verhindert.

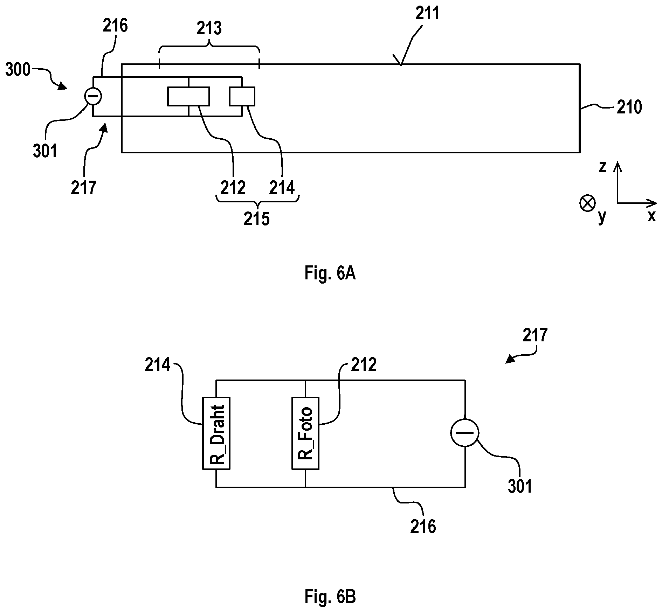

Die Fig. 6A zeigt eine Schnittansicht eines optischen Systems 300 gemäß einer ersten Ausführungsform mit einem optischen Element 210 gemäß einer zweiten Ausführungsform. Das optische Element 210 ähnelt größtenteils dem optischen Element 200 der ersten Ausführungsform und weist ebenfalls eine optische Oberfläche 211, einen Fotowiderstand 212 und einen Bereich 213 auf.

Wie in der Fig. 6A dargestellt, umfasst das optische Element 210 zusätzlich zum Fotowiderstand 212 auch noch ein Heizelement 214, das als ein Heizdraht ausgeführt ist. Gemeinsam bilden der Fotowiderstand 212 und das Heizelement 214 ein Heizmodul 215, welches dem Bereich 213 zugehört. Das optische System 300 der Fig. 6A umfasst zusätzlich zur Linse 210 eine Gleichstromquelle 301, die außerhalb des optischen Elements 210 angeordnet ist und über Stromleitungen 216 mit dem Heizmodul 215 verbunden ist. Zusätzlich zum Fotowiderstand 212 noch einen Heizdraht 214 einzusetzen, ist deshalb vorteilhaft, weil dadurch eine höhere Heizkapazität erzielt wird. Der eingesetzte Heizdraht 214 kann eine Länge von circa 10 cm haben. In weiteren Ausführungsformen kann die Länge des Heizdrahts 214 unterschiedlich sein, insbesondere bei größeren oder kleineren optischen Elementen 210.

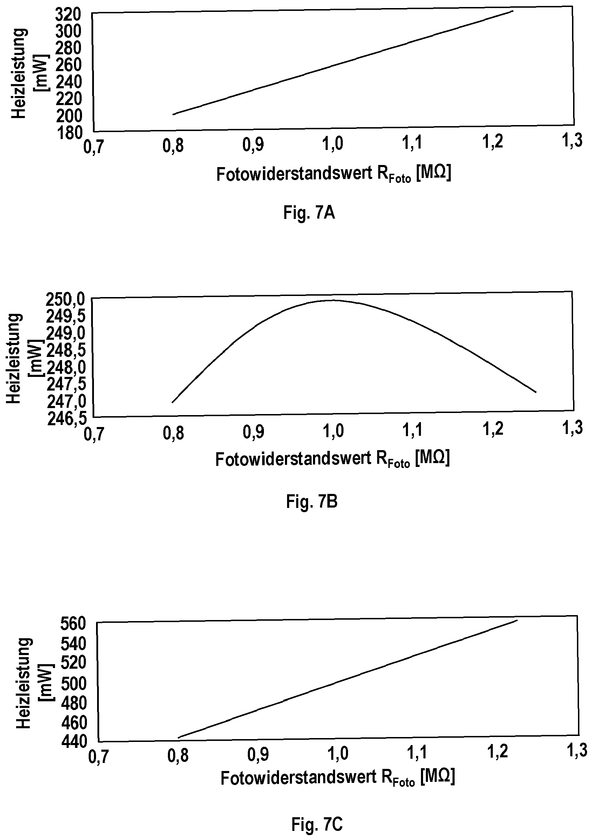

Die Fig. 6B zeigt eine schematische Darstellung eines Stromkreises 217 für das optische System 300 der Fig. 6A. Der Stromkreis 217 umfasst die Gleichstromquelle 301 sowie den Fotowiderstand 212 und den Heizdraht 214, die elektrisch parallel zueinander geschaltet sind. In dem gezeigten Beispiel beträgt ein Dunkelwiderstand des Fotowiderstands 212 (nach mehreren Sekunden ohne Licht) 1,25 MΩ, während ein Hellwiderstand (bei 1000 lx) 0,83 MΩ beträgt. In den Beispielen der Fig. 7A - 7C entspricht ein Drahtwiderstandswert R_{Draht} in etwa dem Fotowiderstandswert R_{Foto}, also R_{Foto} ≈ R_{Draht}. Bei R_{Foto} und R_{Draht} handelt es sich um einen Mittelwert von Hell- und Dunkelwiderstand, also im genannten Beispiel circa 1MQ.

Die Fig. 7A zeigt ein Verhältnis zwischen dem elektrischen Fotowiderstandswert R_{Foto} und der Heizleistung des Heizelements 214. Man erkennt anhand der Fig. 7A, dass die Heizleistung linear proportional zum Fotowiderstandswert R_{Foto} ist. Je größer der Fotowiderstandswert R_{Foto} (also je weniger einfallendes Licht), desto größer ist die Heizleistung durch den Heizdraht 214.

Die Fig. 7B zeigt ein Verhältnis zwischen dem elektrischen Fotowiderstandswert R_{Foto} und der Heizleistung des Fotowiderstand 212. Wie die Fig. 7B zeigt, ist das Verhältnis fast quadratisch. Zudem ist die Heizleistung des Fotowiderstands 212 nahezu konstant.

Die Fig. 7C zeigt ein Verhältnis zwischen dem elektrischen Fotowiderstandswert R_{Foto} und der gesamten Heizleistung des Stromkreises 217. Die Gesamtheizleistung ist bei gleicher Stromstärke und bei gleichgroßen Widerständen (R_{Foto} ≈ R_{Draht}) linear. Das bedeutet, dass der Fotowiderstand 214 als Regelelement für die Gesamtheizleistung des Stromkreises 217 verwendet werden kann.

Die Gesamtheizleistung des Stromkreises 217 mit dem Heizmodul 215 ist somit abhängig von dem elektrischen Fotowiderstandswert R_{Foto}. Daher kann das Heizmodul 215 verwendet werden, um bei Bedarf den Bereich 203 effizient zu erhitzen und Verformungen und/oder Änderungen des Brechungsindex der Linse 210, die durch Lichtabsorption auftreten, zu kompensieren. Die Abbildungsqualität kann dadurch erhöht werden.

Anstelle, wie in der Fig. 6A dargestellt, ein einziges Heizmodul 215 zu verwenden, können innerhalb des optischen Elements 210 auch mehrere Heizmodule 215 mit jeweils einem Fotowiderstand 212 und einem Heizelement 214 eingesetzt werden. Dadurch können unterschiedliche Bereiche 213 der optischen Oberfläche 211 überwacht und beheizt werden.

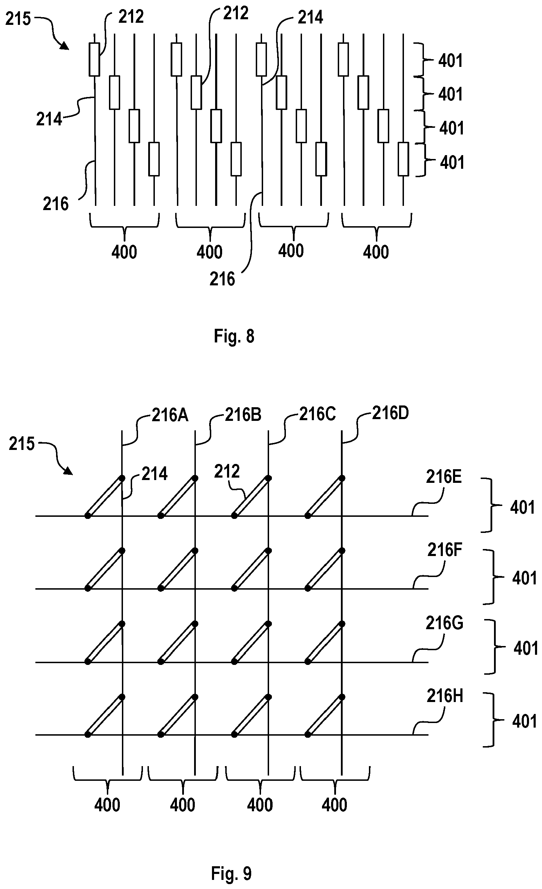

Die Fig. 8 und 9 zeigen Beispiele für die Anordnung einer Vielzahl von Heizmodulen 215. Im Beispiel der Fig. 8 sind sechzehn Heizmodule 215 parallel zueinander in vier Spalten 400 und vier Reihen 401 angeordnet. Jedes Heizmodul 215 hat eine zugeordnete Stromleitung 216, die im Substrat 207 verläuft und das Heizmodul 215 mit Strom von einer Quelle 301 versorgt. Die Heizmodule 215 einer Spalte 400 sind dabei leicht versetzt zueinander in verschiedenen Reihen 401 angeordnet, um ein Verlegen der Leitungen 216 zu ermöglichen.

Die Zuleitungen 216 verlaufen parallel zueinander. Bei einem Gitter von NxN Heizmodulen 215 werden N² Stromleitungen 216 benötigt (N=4 in Fig. 8). Im Beispiel der Fig. 8 sind nur eine Leitung 216 und ein Heizmodul 215 mit einem Bezugszeichen versehen, die übrigen Leitungen 216 und Heizmodule 215 sind jedoch identisch. Im Beispiel der Fig. 8 können die Heizmodule 215 anhand von im Optikteil integrierten Leitungen mit Strom versorgt werden.

Die Fig. 9 zeigt ein zweites Beispiel für eine Anordnung einer Vielzahl von Heizmodulen 215. Die Heizmodule 215 sind in einer Matrixanordnung in regelmäßigen Abständen zueinander angeordnet. Auch hier sind insgesamt sechzehn Heizmodule 215 in vier Spalten 400 und vier Reihen 401 angeordnet. In der Anordnung der Fig. 9 werden deutlich weniger Stromleitungen 216A - 216H benötigt. Bei einem Gitter von NxN Heizmodulen 215 werden 2N Stromleitungen 216A - 216H benötigt (N=4 in Fig. 9). Die Stromversorgung erfolgt im Beispiel der Fig. 9 gemäß einem Multiplexverfahren. Dabei werden die Spaltenleitungen 216A - 216D nacheinander an die Zeilen 216E - 216H angelegt und mit Strom versorgt. Hierzu kann eine in den Fig. 8 und 9 nicht dargestellte Steuereinheit eingesetzt werden, die mit nicht dargestellten Gleichstromquellen verbunden ist und diese ansteuert, damit diese die Heizmodule 215 mit Strom versorgen. Die Ansteuerung der Gleichstromquellen durch die Steuereinheit kann von dem Fotowiderstandswert abhängig sein, um eine Verformung der optischen Oberfläche und/oder eine Änderung des Brechungsindex aufgrund des einfallenden Lichts entgegenzuwirken.

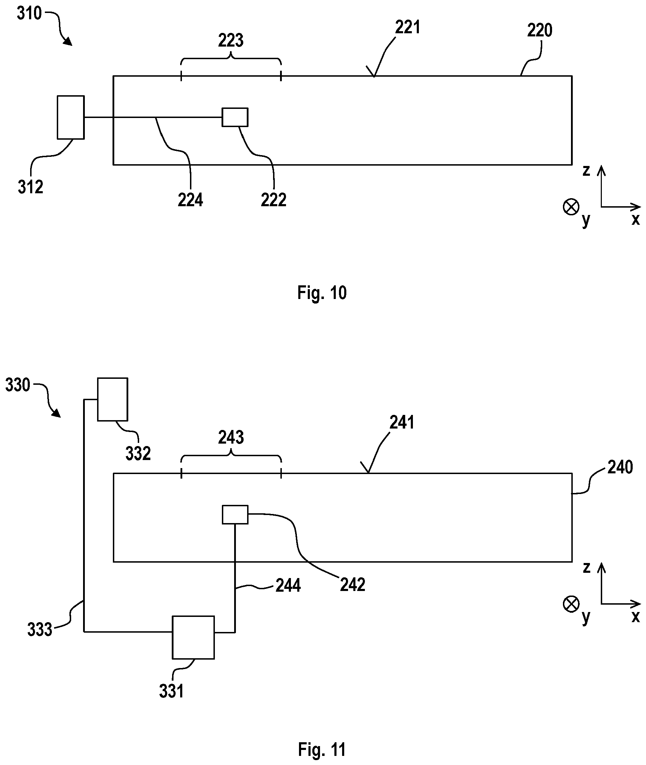

Die Fig. 10 zeigt eine Schnittansicht eines optischen Systems 310 gemäß einer zweiten Ausführungsform mit einem optischen Element 220 gemäß einer dritten Ausführungsform.

Das optische System 310 unterscheidet sich jedoch von dem optischen System 300 der ersten Ausführungsform dadurch, dass das optische System 310 eine Steuereinheit 312 aufweist. Diese ist über die Leitung 224 mit dem Fotowiderstand 222 verbunden. Die Steuereinheit 312 erhält über die Leitung 224 den erfassten Fotowiderstandswert R_{Foto} von dem Fotowiderstand 222. Die Steuereinheit 312 bildet zusammen mit dem Fotowiderstand 222 einen Lichtmesssensor, mit dem das in dem Bereich 223 einfallende Licht erfasst werden kann. Solch ein Lichtmesssensor ist grundsätzlich sowohl in einer EUV-Lithographieanlage 100A als auch in einer DUV-Lithographieanlage 100B verwendbar.

Die Fig. 11 zeigt eine Schnittansicht eines optischen Systems 330 gemäß einer dritten Ausführungsform mit einem optischen Element 240 gemäß einer vierten Ausführungsform. Das optische System 330 ist hier ein Spiegel für eine EUV-Lithographieanlage 100A.

Das optische System 330 umfasst über das optische Element 240 hinaus eine Steuereinheit 331 sowie eine IR-Heizer 332, der ein Heizelement bildet. Die Steuereinheit 331 erhält über eine Leitung 244 den Fotowiderstandswert R_{Foto} von dem Fotowiderstand 242. Die Steuereinheit 332 erzeugt in Abhängigkeit des erfassten Fotowiderstandswerts R_{Foto} ein Steuersignal, das anschließend über eine Leitung 333 an den IR-Heizer 332 gesendet wird. Der IR-Heizer 332 erwärmt den Spiegel 240 und insbesondere den Bereich 243 dem Steuersignal entsprechend.

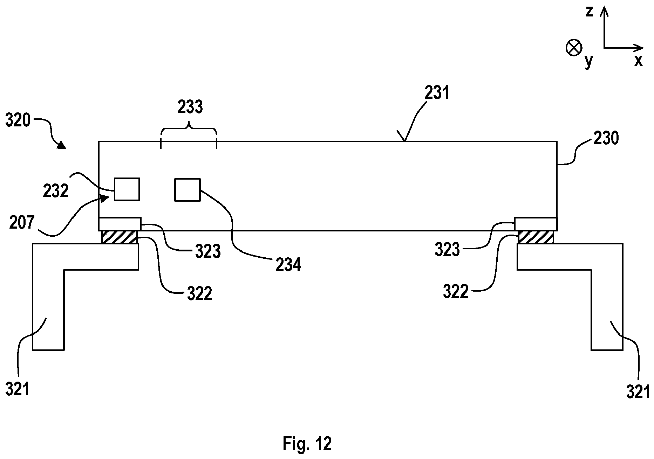

Die Fig. 12 zeigt eine Schnittansicht eines optischen Systems 320 gemäß einer vierten Ausführungsform mit einem optischen Element 230 gemäß einer fünften Ausführungsform.

Die Linse 230 ist mit Kleber 322 an einer Halterung (Rahmen) 321 befestigt. Da der Kleber 322 durch Bestrahlung beschädigt werden kann, wird er durch einen Kleberschutz 323 von der Einstrahlung geschützt. Der Kleberschutz 323 absorbiert Licht jedoch stark, wodurch im Bereich des Kleberschutzes 323 eine starke Verformung und/oder eine Änderung des Brechungsindex erfolgt. Die auf den Kleberschutz 323 einfallende Bestrahlung wird mit dem Fotowiderstand 232, der im Substrat 207 oberhalb des Kleberschutzes 323 angeordnet ist, erfasst. Das zugehörige Heizelement 234 ist etwas beabstandet von dem Fotowiderstand 232 angeordnet, nämlich so, dass das Heizelement 234 einen dem Kleberschutz 323 benachbarten Bereich 233 der optischen Oberfläche 231 erwärmen kann.

Die Verformung und/oder Änderungen des Brechungsindex am Kleberschutz 323 wird anhand des optischen Systems 320 dadurch symmetrisiert (und somit bessert korrigierbar), dass das Heizelement 234 den benachbarten Bereich 233 in Abhängigkeit des Fotowiderstandswerts R_{Foto} weniger beheizt, wenn auf dem Kleberschutz Licht auftritt, als in Bereichen des Kleberschutzes, an denen weniger Licht oder kein Licht auftritt.

Obwohl die vorliegende Erfindung anhand von Ausführungsbeispielen beschrieben wurde, ist sie vielfältig modifizierbar. Die in der Figurenbeschreibung beschriebenen Ausführungsformen können beliebig kombiniert werden. So kann zum Beispiel jedes der optischen Element 200, 210, 220, 230, 240 mehrere Fotowiderstände und/oder Heizelemente umfassen, welche zum Beispiel gemäß den Fig. 8 oder 9 angeordnet sein können. Die Erfindung wird durch die Ansprüche definiert.

### BEZUGSZEICHENLISTE

- 100A: EUV-Lithographieanlage
- 100B: DUV-Lithographieanlage
- 102: Strahlformungs- und Beleuchtungssystem
- 104: Projektionssystem
- 106A: EUV-Lichtquelle
- 106B: DUV-Lichtquelle
- 108A: EUV-Strahlung
- 108B: DUV-Strahlung
- 110: Spiegel
- 112: Spiegel
- 114: Spiegel
- 116: Spiegel
- 118: Spiegel
- 120: Photomaske
- 122: Spiegel
- 124: Wafer
- 126: optische Achse
- 128: Linse
- 130: Spiegel
- 132: Medium
- 200: optisches Element
- 201: optische Oberfläche
- 202: Fotowiderstand
- 203: Bereich der optischen Oberfläche
- 204: Metallkontakt
- 205: Halbleiter
- 206: Oberflächenschicht
- 207: Substrat
- 210: optisches Element
- 211: optische Oberfläche
- 212: Fotowiderstand
- 213: Bereich der optischen Oberfläche
- 214: Heizelement
- 215: Heizmodul
- 216: Stromleitung
- 216A - 216H: Stromleitung
- 217: Stromkreis
- 220: optisches Element
- 221: optische Oberfläche
- 222: Fotowiderstand
- 223: Bereich der optischen Oberfläche
- 224: Leitung
- 230: optisches Element
- 231: optische Oberfläche
- 232: Fotowiderstand
- 233: benachbarter Bereich
- 234: Heizelement
- 240: optisches Element
- 241: optische Oberfläche
- 242: Fotowiderstand
- 243: Bereich der optischen Oberfläche
- 244: Leitung
- 300: optisches Element
- 301: Gleichstromquelle
- 310: optisches Element
- 312: Steuereinheit
- 320: optisches System
- 321: Halterung
- 322: Kleber
- 323: Kleberschutz
- 330: optisches Element
- 331: Steuereinheit
- 332: IR-Heizelement
- 333: Leitung
- 400: Spalte
- 401: Reihe
- h: Höhe
- 1: Länge
- M1: Spiegel
- M2: Spiegel
- M3: Spiegel
- M4: Spiegel
- M5: Spiegel
- M6: Spiegel
- R_{Foto}: Fotowiderstandswert
- R_{Draht}: Drahtwiderstandswert

## Patentansprüche

1. Optisches Element (200, 210, 220, 230, 240) für eine Lithographieanlage (100A, 100B), umfassend:
eine optische Oberfläche (201, 211, 221, 231, 241), und
einen Fotowiderstand (202, 212, 222, 232, 242) mit einem elektrischen Fotowiderstandswert (R_{Foto}), welcher in Abhängigkeit einer Lichtmenge, die auf einen Bereich (203, 213, 223, 243) der optischen Oberfläche (201, 211, 221, 231, 241) einfällt, variiert.

2. Optisches Element nach Anspruch 1, wobei der Fotowiderstand (202, 212, 222, 232, 242) geeignet ist, das optische Element (200, 210, 220, 230, 240) in Abhängigkeit des elektrischen Fotowiderstandswerts (R_{Foto}) derart zu beheizen, dass das Beheizen eine Verformung des optischen Elements (200, 210, 220, 230, 240), die aufgrund des einfallenden Lichts erfolgt, ausgleicht und/oder eine Brechungsindexänderung, die aufgrund des einfallenden Lichts erfolgt, ausgleicht.

3. Optisches Element nach Anspruch 1 oder 2, ferner umfassend:
ein Heizelement (214, 234), das geeignet ist, den Bereich (203, 213, 223, 243) in Abhängigkeit des elektrischen Fotowiderstandswerts (R_{Foto}) zu beheizen, wobei das Heizelement (214, 234) insbesondere parallel zum Fotowiderstand (202, 212, 222, 232, 242) geschaltet ist.

4. Optisches Element nach Anspruch 2 oder 3, wobei das Heizelement (214, 234) in einem Stromkreis (217) elektrisch mit dem Fotowiderstand (202, 212, 222, 232, 242) verbunden ist und eine Änderung des elektrischen Fotowiderstandswerts (R_{Foto}) einen Gesamtwiderstand des Stromkreises (217) derart ändert, dass sich ein Beheizen des Bereichs (203, 213, 223, 243) durch das Heizelement (214, 234) verändert.

5. Optisches Element nach einem der Ansprüche 2 bis 4, wobei das Heizelement (214, 234) eingerichtet ist, den Bereich (203, 213, 223, 243) umso mehr zu beheizen, desto größer der elektrische Fotowiderstandswert (R_{Foto}) ist.

6. Optisches Element nach einem der Ansprüche 1 bis 5, wobei der Fotowiderstand (202, 212, 222, 232, 242) und/oder das Heizelement (214, 234) in einem Substrat (207) des optischen Elements (200, 210, 220, 230, 240) angeordnet ist, wobei das Substrat (207) unterhalb des Bereichs (203, 213, 223, 243) der optischen Oberfläche (201, 211, 221, 231, 241) angeordnet ist.

7. Optisches Element nach einem der Ansprüche 1 bis 6, wobei das optische Element mehrere Fotowiderstände (202, 212, 222, 232, 242) und/oder mehrere Heizelemente (214, 234) umfasst, wobei jeweils ein Fotowiderstand (202, 212, 222, 232, 242) und ein Heizelement (214, 234) zusammen ein Heizmodul (215) bilden, und wobei jedes Heizmodul (215) geeignet ist, einen unterschiedlichen Bereich (203, 213, 223, 243) der optischen Oberfläche (201, 211, 221, 231, 241) zu beheizen.

8. Optisches Element nach Anspruch 6 und 7, wobei jedes Heizmodul (215) geeignet ist, durch eine eigene Stromleitung (216) mit Strom versorgt zu werden, und wobei die Stromleitungen (216) in dem Substrat (207) des optischen Elements (200, 210, 220, 230, 240) angeordnet sind und insbesondere parallel zueinander verlaufen.

9. Optisches Element nach Anspruch 6 und 7 mit zumindest einer Stromleitung (216), die mit mehreren Heizmodulen (215) verbunden ist und geeignet ist, diese mit Strom zu versorgen, insbesondere gemäß einem Multiplexverfahren.

10. Optisches Element nach einem der Ansprüche 1 bis 9, wobei der Fotowiderstand (202, 212, 222, 232, 242) zumindest ein Halbleitermaterial umfasst, wobei das Halbleitermaterial insbesondere amorphes Silizium-Kohlenstoffnitrid (SiCN) oder eine Siliziumkohlenstoff-Legierung (SiC:H) umfasst.

11. Optisches System (300, 310, 320, 330) für eine Lithographieanlage (100A, 100B), aufweisend:
ein optisches Element (200, 210, 220, 230, 240) nach einem der Ansprüche 1 bis 10, und
zumindest eine Gleichstromquelle (301), die geeignet ist, den Fotowiderstand (202, 212, 222, 232, 242) und/oder das Heizelement (214, 234) mit Strom zu versorgen, und/oder
eine Steuereinheit (312, 331), die geeignet ist, in Abhängigkeit des elektrischen Fotowiderstandswerts (R_{Foto}) das Beheizen des Bereichs (203, 213, 223, 243) der optischen Oberfläche (201, 211, 221, 231, 241) durch den Fotowiderstand (202, 212, 222, 232, 242) und/oder durch das Heizelement (214, 234) anzusteuern, und/oder
ein externes Heizelement (332), insbesondere ein IR-Heizelement, das geeignet ist, einen Bereich (233) in Abhängigkeit des elektrischen Fotowiderstandswerts (R_{Foto}) zu beheizen.

12. Lithographieanlage (100A, 100B), insbesondere EUV- oder DUV-Lithographieanlage, mit einem optischen Element (200, 210, 220, 230, 240) nach einem der Ansprüche 1 bis 10 oder einem optischen System (300, 310, 320, 330) nach Anspruch 11.

13. Verfahren zum Betreiben eines optischen Elements (200, 210, 220, 230, 240) einer Lithographieanlage (100A, 100B), insbesondere des optischen Elements (200, 210, 220, 230, 240) nach einem der Ansprüche 1 bis 10, umfassend:
Erfassen eines elektrischen Fotowiderstandswerts (R_{Foto}) eines Fotowiderstands (202, 212, 222, 232, 242), wobei der elektrische Fotowiderstandswert (R_{Fo-to}) in Abhängigkeit einer Lichtmenge, die auf einen Bereich (203, 213, 223, 243) der optischen Oberfläche (201, 211, 221, 231, 241) einfällt, variiert; und
Beheizen der optischen Oberfläche (201, 211, 221, 231, 241), insbesondere des Bereichs (203, 213, 223, 243), in Abhängigkeit des elektrischen Fotowiderstandswerts (R_{Foto}).

14. Verfahren nach Anspruch 13, wobei das Beheizen der optischen Oberfläche (201, 211, 221, 231, 241) mit dem Fotowiderstand (202, 212, 222, 232, 242) und/oder einem Heizelement (214, 234) erfolgt.

15. Verfahren nach Anspruch 13 oder 14, ferner umfassend:
Beheizen des Bereichs (203, 213, 223, 243) in Abhängigkeit des elektrischen Fotowiderstandswert (R_{Foto}) mithilfe eines Heizelements (214, 234), das elektrisch mit dem Fotowiderstand (202, 212, 222, 232, 242) verbunden ist, wobei eine Änderung des elektrischen Fotowiderstandswerts (R_{Foto}) einen Gesamtwiderstand des Stromkreises (217) derart ändert, dass sich ein Beheizen des Bereichs (203, 213, 223, 243) durch das Heizelement (214, 234) verändert; und/oder
Ansteuern des Heizelements (214, 234) in Abhängigkeit des erfassten elektrischen Fotowiderstandswerts (R_{Foto}) durch die Steuereinheit (312, 331); und/oder
Beheizen eines Bereichs aufweisend einen Kleberschutz (323) in Abhängigkeit des elektrischen Fotowiderstandswerts (R_{Foto}) mithilfe des Heizelements (214, 234), wobei der Kleberschutz (323) einen Kleber (322) überdeckt, der zum Verbinden des optischen Elements (200, 210, 220, 230, 240) mit einer Halterung (321) verwendet wird.

## Claims

1. Optical element (200, 210, 220, 230, 240) for a lithography apparatus (100A, 100B), comprising:
an optical surface (201, 211, 221, 231, 241) and
a photoresistor (202, 212, 222, 232, 242) having an electrical photoresistance value (Rphoto) which varies dependent on an amount of luminous energy incident on a region (203, 213, 223, 243) of the optical surface (201, 211, 221, 231, 241).

2. Optical element according to Claim 1, wherein the photoresistor (202, 212, 222, 232, 242) is suitable for heating the optical element (200, 210, 220, 230, 240) dependent on the electrical photoresistance value (Rphoto), in such a way that the heating compensates a deformation of the optical element (200, 210, 220, 230, 240) that occurs due to the incident light and/or a refractive index change that occurs due to the incident light.

3. Optical element according to Claim 1 or 2, further comprising:
a heating element (214, 234) suitable for heating the region (203, 213, 223, 243) dependent on the electrical photoresistance value (Rphoto), the heating element (214, 234) being connected in parallel with the photoresistor (202, 212, 222, 232, 242) in particular.

4. Optical element according to Claim 2 or 3, wherein the heating element (214, 234) is electrically connected to the photoresistor (202, 212, 222, 232, 242) in an electrical circuit (217) and a change in the electrical photoresistance value (Rphoto) changes a total resistance of the electrical circuit (217) in such a way that there is a change in heating of the region (203, 213, 223, 243) by the heating element (214, 234).

5. Optical element according to any one of Claims 2 to 4, wherein the heating element (214, 234) is configured to heat the region (203, 213, 223, 243) more, the greater the electrical photoresistance value (Rphoto).

6. Optical element according to any one of Claims 1 to 5, wherein the photoresistor (202, 212, 222, 232, 242) and/or the heating element (214, 234) is/are arranged in a substrate (207) of the optical element (200, 210, 220, 230, 240), the substrate (207) being arranged below the region (203, 213, 223, 243) of the optical surface (201, 211, 221, 231, 241).

7. Optical element according to any one of Claims 1 to 6, wherein the optical element comprises a plurality of photoresistors (202, 212, 222, 232, 242) and/or a plurality of heating elements (214, 234), one photoresistor (202, 212, 222, 232, 242) and one heating element (214, 234) together forming a heating module (215) in each case and each heating module (215) being suitable for heating a different region (203, 213, 223, 243) of the optical surface (201, 211, 221, 231, 241).

8. Optical element according to Claims 6 and 7, wherein each heating module (215) is suitable for being supplied with current by a dedicated power supply line (216) and wherein the power supply lines (216) are arranged within the substrate (207) of the optical element (200, 210, 220, 230, 240) and in particular run parallel to one another.

9. Optical element according to Claims 6 and 7, comprising at least one power supply line (216) which is connected to a plurality of heating modules (215) and suitable for supplying the latter with power, in particular according to a multiplex method.

10. Optical element according to any one of Claims 1 to 9, wherein the photoresistor (202, 212, 222, 232, 242) comprises at least one semiconductor material, the semiconductor material comprising amorphous silicon carbon nitride (SiCN) or a silicon carbon alloy (SiC:H) in particular.

11. Optical system (300, 310, 320, 330) for a lithography apparatus (100A, 100B), comprising:
an optical element (200, 210, 220, 230, 240) according to any one of Claims 1 to 10, and
at least one direct current source (301) suitable for supplying current to the photoresistor (202, 212, 222, 232, 242) and/or the heating element (214, 234), and/or
a control unit (312, 331) suitable for controlling, dependent on the electrical photoresistance value (Rphoto), the heating of the region (203, 213, 223, 243) of the optical surface (201, 211, 221, 231, 241) by the photoresistor (202, 212, 222, 232, 242) and/or by the heating element (214, 234), and/or
an external heating element (332), in particular an IR heating element, suitable for heating a region (233) dependent on the electrical photoresistance value (Rphoto).

12. Lithography apparatus (100A, 100B), in particular an EUV or DUV lithography apparatus, comprising an optical element (200, 210, 220, 230, 240) according to any one of Claims 1 to 10 or an optical system (300, 310, 320, 330) according to Claim 11.

13. Method for operating an optical element (200, 210, 220, 230, 240) of a lithography apparatus (100A, 100B), in particular the optical element (200, 210, 220, 230, 240) according to any one of Claims 1 to 10, comprising:
sensing an electrical photoresistance value (Rphoto) of a photoresistor (202, 212, 222, 232, 242), the electrical photoresistance value (Rphoto) varying dependent on an amount of luminous energy incident on a region (203, 213, 223, 243) of the optical surface (201, 211, 221, 231, 241); and
heating the optical surface (201, 211, 221, 231, 241), in particular the region (203, 213, 223, 243), dependent on the electrical photoresistance value (Rphoto).

14. Method according to Claim 13, wherein the optical surface (201, 211, 221, 231, 241) is heated using the photoresistor (202, 212, 222, 232, 242) and/or a heating element (214, 234).

15. Method according to Claim 13 or 14, further comprising:
heating the region (203, 213, 223, 243) dependent on the electrical photoresistance value (Rphoto) by means of a heating element (214, 234) electrically connected to the photoresistor (202, 212, 222, 232, 242), a change in the electrical photoresistance value (Rphoto) changing a total resistance of the electrical circuit (217) such that there is a change in heating of the region (203, 213, 223, 243) by the heating element (214, 234); and/or
controlling the heating element (214, 234) by means of the control unit (312, 331) dependent on the sensed electrical photoresistance value (Rphoto); and/or
heating a region containing an adhesive protector (323) dependent on the electrical photoresistance value (Rphoto) using the heating element (214, 234), the adhesive protector (323) covering an adhesive (322) used to connect the optical element (200, 210, 220, 230, 240) to a mount (321).

## Revendications

1. Élément optique (200, 210, 220, 230, 240) destiné à une installation de lithographie (100A, 100B), ledit élément optique comprenant :
une surface optique (201, 211, 221, 231, 241), et
une photorésistance (202, 212, 222, 232, 242) ayant une valeur de photorésistance électrique (R_{Foto}) qui varie en fonction de la quantité de lumière qui est incidente à une zone (203, 213, 223, 243) de la surface optique (201, 211, 221, 231, 241).

2. Élément optique selon la revendication 1, la photorésistance (202, 212, 222, 232, 242) étant adaptée pour chauffer l'élément optique (200, 210, 220, 230, 240) en fonction de la valeur de photorésistance électrique (R_{Foto}) de manière que le chauffage compense une déformation de l'élément optique (200, 210, 220, 230, 240) qui se produit en raison de la lumière incidente, et/ou compense une modification de l'indice de réfraction qui se produit en raison de la lumière incidente.

3. Élément optique selon la revendication 1 ou 2, comprenant en outre :
un élément chauffant (214, 234) qui est adapté à chauffer la zone (203, 213, 223, 243) en fonction de la valeur de photorésistance électrique (R_{Foto}), l'élément chauffant (214, 234) étant notamment monté en parallèle avec la photorésistance (202, 212, 222, 232, 242).

4. Élément optique selon la revendication 2 ou 3, l'élément chauffant (214, 234) étant relié électriquement à la photorésistance (202, 212, 222, 232, 242) dans un circuit électrique (217) et une variation de la valeur de photorésistance électrique (R_{Foto}) faisant varier une résistance totale du circuit électrique (217) de manière à faire varier le chauffage de la zone (203, 213, 223, 243) par l'élément chauffant (214, 234).

5. Élément optique selon l'une des revendications 2 à 4, l'élément chauffant (214, 234) étant conçu pour chauffer la zone (203, 213, 223, 243) d'autant plus que la valeur de photorésistance électrique (R_{Foto}) est grande.

6. Élément optique selon l'une des revendications 1 à 5, la photorésistance (202, 212, 222, 232, 242) et/ou l'élément chauffant (214, 234) étant disposés dans un substrat (207) de l'élément optique (200, 210, 220, 230, 240), le substrat (207) étant disposé au-dessous de la zone (203, 213, 223, 243) de la surface optique (201, 211, 221, 231, 241).

7. Élément optique selon l'une des revendications 1 à 6, l'élément optique comprenant plusieurs photorésistances (202, 212, 222, 232, 242) et/ou plusieurs éléments chauffants (214, 234), une photorésistance (202, 212, 222, 232, 242) et un élément chauffant (214, 234) formant conjointement à chaque fois un module chauffant (215), et chaque module chauffant (215) étant adapté pour chauffer une zone différente (203, 213, 223, 243) de la surface optique (201, 211, 221, 231, 241).

8. Élément optique selon les revendications 6 et 7, chaque module chauffant (215) étant adapté pour être alimenté en courant par sa propre ligne électrique (216), et les lignes électriques (216) étant disposées dans le substrat (207) de l'élément optique (200, 210, 220, 230, 240) et s'étendant notamment parallèlement les unes aux autres.

9. Élément optique selon les revendications 6 et 7 comprenant au moins une ligne électrique (216) qui est reliée à plusieurs modules chauffants (215) et qui est adaptée pour les alimenter en courant, notamment selon un procédé de multiplexage.

10. Élément optique selon l'une des revendications 1 à 9, la photorésistance (202, 212, 222, 232, 242) comprenant au moins un matériau semi-conducteur, le matériau semi-conducteur comprenant notamment du nitrure de silicium-carbone amorphe (SiCN) ou un alliage silicium-carbone (SiC:H).

11. Système optique (300, 310, 320, 330) destiné à une installation de lithographie (100A, 100B), ledit système optique comprenant :
un élément optique (200, 210, 220, 230, 240) selon l'une des revendications 1 à 10, et
au moins une source de courant continu (301) qui est adaptée pour alimenter en courant la photorésistance (202, 212, 222, 232, 242) et/ou l'élément chauffant (214, 234), et/ou
une unité de commande (312, 331) qui est adaptée pour commander le chauffage de la zone (203, 213, 223, 243) de la surface optique (201, 211, 221, 231, 241) par la photorésistance (202, 212, 222, 232, 242) et/ou par l'élément chauffant (214, 234) en fonction de la valeur de photorésistance électrique (R_{Foto}), et/ou
un élément chauffant extérieur (332), notamment un élément chauffant IR, qui est adapté pour chauffer une zone (233) en fonction de la valeur de photorésistance électrique (R_{Foto}).

12. Installation de lithographie (100A, 100B), notamment installation de lithographie EUV ou DUV, comprenant un élément optique (200, 210, 220, 230, 240) selon l'une des revendications 1 à 10 ou un système optique (300, 310, 320, 330) selon la revendication 11.

13. Procédé de fonctionnement d'un élément optique (200, 210, 220, 230, 240) d'une installation de lithographie (100A, 100B), notamment de l'élément optique (200, 210, 220, 230, 240) selon l'une des revendications 1 à 10, ledit procédé comprenant les étapes suivantes :
acquérir une valeur de photorésistance électrique (R_{Foto}) d'une photorésistance (202, 212, 222, 232, 242), la valeur de photorésistance électrique (R_{Foto}) variant en fonction d'une quantité de lumière qui est incidente à une zone (203, 213, 223, 243) de la surface optique (201, 211, 221, 231, 241) ; et
chauffer la surface optique (201, 211, 221, 231, 241), notamment la zone (203, 213, 223, 243), en fonction de la valeur de photorésistance électrique (R_{Foto}).

14. Procédé selon la revendication 13, le chauffage de la surface optique (201, 211, 221, 231, 241) étant effectué avec la photorésistance (202, 212, 222, 232, 242) et/ou un élément chauffant (214, 234).

15. Procédé selon la revendication 13 ou 14, comprenant en outre les étapes suivantes :
chauffer la zone (203, 213, 223, 243) en fonction de la valeur de photorésistance électrique (R_{Foto}) à l'aide d'un élément chauffant (214, 234) qui est relié électriquement à la photorésistance (202, 212, 222, 232, 242), la variation de la valeur de photorésistance électrique (R_{Foto}) faisant varier la résistance totale du circuit électrique (217) de manière à faire varier le chauffage de la zone (203, 213, 223, 243) par l'élément chauffant (214, 234) ; et/ou
commander l'élément chauffant (214, 234) en fonction de la valeur de photorésistance électrique acquise (R_{Foto}) par le biais de l'unité de commande (312, 331) ; et/ou
chauffer une zone comportant une protection d'adhésif (323) en fonction de la valeur de photorésistance électrique (R_{Foto}) à l'aide de l'élément chauffant (214, 234), la protection d'adhésif (323) recouvrant un adhésif (322) qui est utilisé pour relier l'élément optique (200, 210, 220, 230, 240) à un support (321).
